# EUROPEAN PATENT SPECIFICATION

(11) **EP 3 149 787 B1**
(45) Date of publication and mention of the grant of the patent: **06.05.2020**
(21) Application number: 15798705.8
(22) Date of filing: 28.05.2015
(51) Int. Cl.: H01L 51/46, C08G 61/12

(54) **COMPOSITIONS AND APPLICATIONS OF THREE COMPONENT BENZO[1,2-B:4,5-B]DITHIOPHENE-THIENOTHIOPHENE RANDOMLY SUBSTITUTED POLYMERS FOR ORGANIC SOLAR CELLS**
ZUSAMMENSETZUNGEN UND ANWENDUNGEN VON ZUFÄLLIG SUBSTITUIERTEN DREIKOMPONENTIGEN BENZO[1,2-B:4,5-B]DITHIOPHEN-THIENOTHIOPHEN-POLYMEREN FÜR ORGANISCHE SOLARZELLEN
COMPOSITIONS ET APPLICATIONS DE POLYMÈRES TRICOMPOSANTS DE BENZO [1,2-B: 4,5-B]DITHIOPHÈNE-THIÉNOTHIOPHÈNE À SUBSTITUTION ALÉATOIRE POUR DES CELLULES SOLAIRES ORGANIQUES

(30) Priority: 30.05.2014 US 201462005178 P; 27.05.2015 US 201514772409
(43) Date of publication of application: 05.04.2017
(73) Proprietor: Phillips 66 Company, Houston TX 77210 (US)
(72) Inventor: WOODY, Kathy, Bartlesville, Oklahoma 74006 (US); HUANG, Hui, Beijing (CN); HE, Ting, Idaho Falls, ID 83404 (US)
(74) Representative: HGF B.V.
(86) International application number: PCT/US2015/032813
(87) International publication number: WO 2015/184054

(56) References cited:
- EP-A1- 2 399 947
- WO-A1-2014/038526
- WO-A1-2014/069468
- US-A1- 2014 042 371
- KIM ET AL.: 'Thieno[3,2-b]thiophene-substituted Benzo[1,2-b:4,5-b?]dithiophene as a Promising Building Block for Low Bandgap Semiconducting Polymers for High Performance Single and Tandem Organ' CHEMISTRY OF MATERIALS vol. 26, January 2014, pages 1234 - 1242, XP002591184

## Description

### CROSS-REFERENCE TO RELATED APPLICATIONS

This application is a PCT International application which claims the benefit of and priority to U.S. Provisional Application Ser. No. 62/005,178 filed May 30, 2014 and U.S. Application Serial No. 14/772,409 filed May 27, 2015, entitled " Compositions and Applications of Three Component Benzo[1,2-B:4,5-B] Dithiophene-Thienothiophene Randomly Substituted Conjugated Polymers for Organic Solar Cells".

### STATEMENT REGARDING FEDERALLY SPONSORED RESEARCH OR DEVELOPMENT

None.

### FIELD OF THE INVENTION

This invention relates to a three component benzo[1,2-b:4,5-b]dithiophene-thienothiophene polymer, and use thereof in electronic devices.

### BACKGROUND OF THE INVENTION

Solar energy using photovoltaic effect requires active semiconducting materials to convert light into electricity. Currently, solar cells based on silicon are the dominating technology due to their high conversion efficiency. Recently, solar cells based on organic materials showed interesting features, especially on the potential of low cost in materials and processing. Judging from the recent success in organic light emitting diodes based on a reverse effect of photovoltaic effect, organic solar cells are very promising.

Organic photovoltaic cells have many potential advantages when compared to traditional silicon-based devices. Organic photovoltaic cells are light weight, economical in the materials used, and can be deposited on low cost substrates, such as flexible plastic foils. However, organic photovoltaic devices typically have relatively low quantum yield (the ratio of photons absorbed to carrier pairs generated. This is, in part, thought to be due to the second order nature of the intrinsic photoconductive process. That is, carrier generation requires exciton generation, diffusion and ionization. The diffusion length of an exciton is typically much less than the optical absorption length, requiring a trade off between using a thick, and therefore resistive, cell with multiple or highly folded interfaces, or a thin cell with a low optical absorption efficiency.

Conjugated polymers are polymers containing z-electron conjugated units along the main chain. They can be used as active layer materials for some types of photo-electric devices such as polymer light emitting devices, polymer solar cells, polymer field effect transistors, etc As polymer solar cell materials, conjugated polymers should possess some properties, such as high mobility, good harvest of sunlight, good processibility, and proper molecular energy level Some conjugated polymers have proven to be good solar cell materials. Conjugated polymers are made of alternating single and double covalent bonds. The conjugated polymers have a 8-bond backbone of intersecting sp² hybrid orbitals. The Pz orbitals on the carbon atoms overlap with neighboring Pz orbitals to provide n-bonds. The electrons that comprise the n-bonds are delocalized over the whole molecule. These polymers exhibit electronic properties similar to those seen in inorganic semiconductors. The semiconducting properties of the photovoltaic polymers are derived from their delocalized *n* bonds. The substituents of the polymers also largely influence the electronic properties. The optical bandgap, mobility and thin-film morphology are affected by both the type of functional group used as a substituent and the bulkiness and length of the side chain. Polymers which have only minor differences in the side chains will have large differences in the device performance.

There is a need in the art for polymer solar cells that exhibit increased solar conversion efficiency. WO2014069468 describes an organic thin film solar cell. EP2399947 describes electron donating polymers and organic solar cells using the same.

### BRIEF SUMMARY OF THE DISCLOSURE

The present invention provides a polymer having two different sets of repeat units consisting essentially of 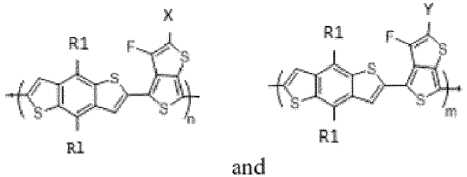
wherein R1 are selected from the group consisting of alkyl group, alkoxy group, aryl groups and combinations thereof;
n and m are greater than 1; and
x and y are different from each other and selected from 2-ethylhexyl and propyl; wherein the two sets of repeat units are a R1 substituted benzo[1,2-b:4,5-b']dithiophene with a 2-ethylhexyl substituted 3-fluorothieno[3,4-b]thiophene and a R1 substituted benzo[1,2-b:4,5-b']dithiophene with a propyl substituted 3-fluorothieno [3,4-b]thiophene.

### BRIEF DESCRIPTION OF THE DRAWINGS

A more complete understanding of the present invention and benefits thereof may be acquired by referring to the follow description taken in conjunction with the accompanying drawings in which:

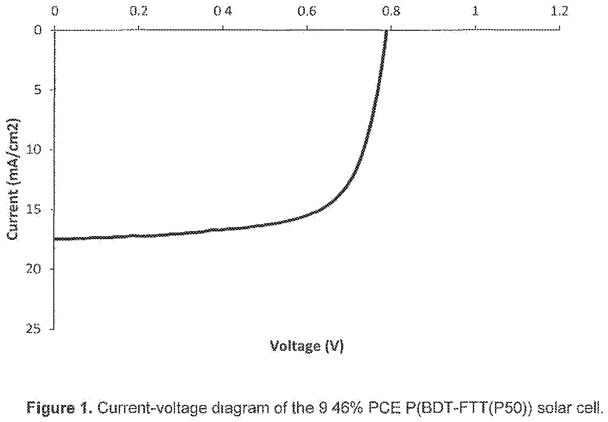

Figure 1 depicts a current-voltage diagram of a solar cell

### DETAILED DESCRIPTION

Turning now to the detailed description of the preferred arrangement or arrangements of the present invention, it should be understood that the inventive features and concepts may be manifested in other arrangements and that the scope of the invention is not limited to the embodiments described or illustrated. The scope of the invention is intended only to be limited by the scope of the claims that follow.

"Alkyl," as used herein, refers to an aliphatic hydrocarbon chains. In one embodiment the aliphatic hydrocarbon chains are of 1 to about 100 carbon atoms, preferably 1 to 30 carbon atoms, more preferably, 1 to 20 carbon atoms, and even more preferably, 1 to 10 carbon atoms and includes straight and branched chains such as methyl, ethyl, n-propyl, isopropyl, n-butyl, isobutyl, sec-butyl, t-butyl, n-pentyl, isopentyl, neo-pentyl, n-hexyl, and isohexyl. In this application alkyl groups can include the possibility of substituted and unsubstituted alkyl groups.

"Alkoxy," as used herein, refers to the group R-O- where R is an alkyl group of 1 to 100 carbon atoms. In this application alkoxy groups can include the possibility of substituted and unsubstituted alkoxy groups.

"Aryl" as used herein, refers to an optionally substituted, mono-, di-, tri-, or other multicyclic aromatic ring system having from about 5 to about 50 carbon atoms (and all combinations and subcombinations of ranges and specific numbers of carbon atoms therein), with from about 6 to about 10 carbons being preferred. Non-limiting examples include, for example, phenyl, naphthyl, anthracenyl, and phenanthrenyl. Aryl groups can be optionally substituted with one or with one or more Rx. In this application aryl groups can include the possibility of substituted aryl groups, bridged aryl groups and fused aryl groups.

The present embodiment describes a polymer with only two different sets of repeat units.

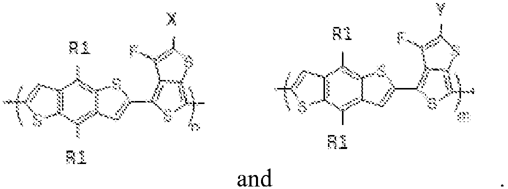

In this polymer R1 can be selected from alkyl groups, alkoxy groups and aryl groups and n and m are greater than 1. x and y are different from each other and are 2-ethylhexyl and propyl, respectively.

In one embodiment, the polymer is regio-random. In another embodiment the polymer is regio-regular.

In one embodiment, the two sets of repeat units are a R1 substituted benzo[1,2-b:4,5-b']dithiophene with a 2-ethylhexyl substituted 3-fluorothieno[3,4-b]thiophene and a R1 substituted benzo[1,2-b:4,5-b']dithiophene with a propyl substituted 3-fluorothieno[3,4-b]thiophene. In another embodiment, the two sets of repeat units can be a R1 substituted benzo[1,2-b:4,5-b']dithiophene with a 2-ethylhexyl substituted 3-fluorothieno[3,4-b]thiophene and a R1 substituted benzo[1,2-b:4,5-b']dithiophene with a propyl substituted 3-fluorothieno[3,4-b]thiophene in a ratio of around 50:50. In yet another embodiment, not according to the invention, the two sets of repeat units can be a 2-ethyl-1-(3-fluorothieno[3,4-b]thiophen-2-yl)hexan-1-one and a 1-(3-fluorothieno[3,4-b]thiophen-2-yl)butan-1-one in a ratio of around 50:50.

Typically, the number average molecular weight of the polymers is in the range of approximately 1000 to 1,000,000, with ideal polymers having a number average molecular weight in the range of about 5000 to 500,000, and some ideal polymers having a number average molecular weight in the range of approximately 20,000 to 200,000. It will be appreciated that molecular weight can be varied to optimize polymer properties and the inventions of the present disclosure cover all molecular weights. For example, lower molecular weight can ensure solubility, while a higher molecular weight can ensure good film-forming properties.

In one embodiment, the ratio of 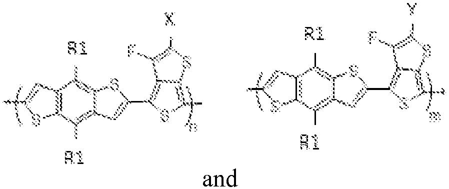 in the polymer is around 50:50.

The polymers produced from the present disclosure can be used as photovoltaic materials or active layer material in photovoltaic device or electronic devices such as photodetector devices, solar cell devices, and the like. Photovoltaic devices, including polymer solar cell devices or photodetector devices, are generally comprised of laminates of a suitable photovoltaic material between a hole-collecting electrode layer and an electron-collecting layer. Additional layers, elements or a substrate may or may not be present. Examples of electronic devices can be field effect transistors, light emitting devices, and sensors, electrochromic devices and capacitors

### Examples:

### List of acronyms used:

BDT: Benzo[1,2-b:4,5-b']dithiophene
FTT: 3-Fluorothieno[3,4-b]thiophene
FTT(E): 2-ethylhexyl 3-fluorothieno[3,4-b]thiophene-2-carboxylate
FTT(P): propyl 3-fluorothieno[3,4-b]thiophene-2-carboxylate
FTT(M): methyl 3-fluorothieno[3,4-b]thiophene-2-carboxylate
FTT(K1): 2-ethyl-1-(3-fluorothieno[3,4-b]thiophen-2-yl)hexan-1-one
FTT(K2): 1-(3-fluorothieno[3,4-b]thiophen-2-yl)butan-1-one
PCE: power conversion efficiency
Jsc: short circuit current
Voc: open circuit voltage
PDI: polydispersity index
*M*ₙ: number average molecular weight defined by (∑NiMi)/∑Ni where Mi is the molecular weight of a chain and Ni is the number of chains of that molecular weight
Soxhlet Extraction: The polymer is washed using a reflux apparatus with different solvents. The solvent and polymer is then heated till the solvent evaporates into a gas, then cools into a liquid. The solvent is then evaporated off and polymer products are produced.

### Example 1 (not according to the invention):

P(BDT-FTT(P)), (100% FTT(P)): Monomers BDT (0.228 g, 0.252 mmol) and FTT(P) (0.101 g, 0.251 mmol) were combined in a Schlenk flask with Pd(PPh₃)₄ (14 mg), toluene (10 mL) and dimethylformamide (4 mL). The solution was heated to 130 °C and stirred for 36 h. The solution was poured into 100 mL methanol and the polymer was collected by filtration. The polymer was purified by Soxhlet extraction by washing subsequently with acetone, hexanes and chloroform. The polymer was recovered in the chloroform fraction (*M*ₙ = 40 kDa and PDI =2.08).

### Example 2 (not according to the invention):

P((BDT-FTT(P))_{0.7}-(BDT-FTT(E))_{0.3}), (70% FTT(P), 30% FTT(E)): Monomers distannyl-BDT (0.142 g, 0.157 mmol), dibromo-FTT(E) (0.022 g, 0.047 mmol) and dibromo-FTT(P) (0.044 g, 0.109 mmol) were combined in a Schlenk flask with Pd(PPh₃)₄ (12 mg), toluene (7 mL) and DMF (2.5 mL). The solution was heated to 130 °C and stirred for 24 h. The solution was poured into 100 mL methanol and the polymer was collected by filtration. The polymer was purified by Soxhlet extraction by washing subsequently with acetone, hexanes and chloroform. The polymer was recovered in the chloroform fraction (*M*ₙ = 17 kDa and PDI = 3.70).

### Example 3 (not according to the invention):

P((BDT-FTT(P))_{0.5}-(BDT-FTT(E))_{0.5}), (50% FTT(P), 50% FTT(E)): Monomers distannyl-BDT (0.108 g, 0.119 mmol), dibromo-FTT(E) (0.028 g, 0.059 mmol) and dibromo-FTT(P) (0.024 g, 0.059 mmol) were combined in a Schlenk flask with Pd(PPh₃)₄ (7 mg), toluene (6 mL) and DMF (2 mL). The solution was heated to 130 °C and stirred for 24 h. The solution was poured into 100 mL methanol and the polymer was collected by filtration. The polymer was purified by Soxhlet extraction by washing subsequently with acetone, hexanes and chloroform. The polymer was recovered in the chloroform fraction (*M*ₙ = 34 kDa and PDI = 3.17).

### Example 4 (not according to the invention):

P((BDT-FTT(P))_{0.3}-(BDT-FTT(E))_{0.7}), (30% FTT(P), 70% FTT(E)): Monomers distannyl-BDT (0.080 g, 0.088 mmol), dibromo-FTT(E) (0.029 g, 0.061 mmol) and dibromo-FTT(P) (0.011 g, 0.027 mmol) were combined in a Schlenk flask with Pd(PPh₃)₄ (5 mg), toluene (6 mL) and DMF (3 mL). The solution was heated to 130 °C and stirred for 36 h. The solution was poured into 100 mL methanol and the polymer was collected by filtration. The polymer was purified by Soxhlet extraction by washing subsequently with acetone, hexanes and chloroform. The polymer was recovered in the chloroform fraction (*M*ₙ = 63 kDa and PDI = 2.96).

### Example 5 (not according to the invention):

P((BDT-FTT(P))_{0.1}-(BDT-FTT(E))_{0.9}) (10% FTT(P), 90% FTT(E)): Monomers distannyl-BDT (0.093 g, 0.103 mmol), dibromo-FTT(E) (0.044 g, 0.093 mmol) and dibromo-FTT(P) (0.004 g, 0.010 mmol) were combined in a Schlenk flask with Pd(PPh₃)₄ (6 mg), toluene (6 mL) and DMF (2 mL). The solution was heated to 130 °C and stirred for 24 h. The solution was poured into 100 mL methanol and the polymer was collected by filtration. The polymer was purified by Soxhlet extraction by washing subsequently with acetone, hexanes and chloroform. The polymer was recovered in the chloroform fraction (*M*ₙ = 24 kDa and PDI = 2.08).

### Example 6 (not according to the invention):

P(BDT-FTT(E)), (100% FTT(E)): Monomers distannyl-BDT (0.115 g, 0.127 mmol)) and dibromo-FTT(E) (0.060 g, 0.127 mmol) were combined in a Schlenk flask with Pd(PPh₃)₄ (7 mg) in toluene (4 mL) and DMF (1 mL). The solution was heated to 115 °C and stirred for 96 h. The solution was poured into 100 mL methanol and the polymer was collected by filtration. The polymer was purified by Soxhlet extraction by washing subsequently with acetone, hexanes and chloroform. The polymer was recovered in the chloroform fraction (*M*ₙ = 24 kDa and PDI = 2.1).

### Example 7 (not according to the invention):

P((BDT-FTT(E))_{0.25}-(BDT-FTT(K1))_{0.75}) Monomers distannyl-BDT (0.10 g, 0.11 mmol)), dibromo-FTT(E) (13 mg, 0.0275 mmol) and dibromo-FTT(Kl) (36.5 mg, 0.0825 mmol) were combined in a Schlenk flask with Pd(PPh₃)₄ (12.8 mg) in toluene (4.4 mL) and DMF (1.1 mL). The solution was heated to 120 °C and stirred for 48 h. The solution was poured into 100 mL methanol and the polymer was collected by filtration. The polymer was purified by Soxhlet extraction by washing subsequently with acetone, hexanes and chloroform. The polymer was recovered in the chloroform fraction (*M*ₙ = 41 kDa and PDI = 2.9).

### Example 8 (not according to the invention):

P((BDT-FTT(E))_{0.5}-(BDT-FTT(K1))_{0.5}) Monomers distannyl-BDT (100 mg, 0.11 mmol)), dibromo-FTT(E) (26 mg, 0.055 mmol) and dibromo-FTT(Kl) (24 mg, 0.055 mmol) were combined in a Schlenk flask with Pd(PPh₃)₄ (13 mg) in toluene (4.4 mL) and DMF (1.1 mL). The solution was heated to 120 °C and stirred for 48 h. The solution was poured into 100 mL methanol and the polymer was collected by filtration. The polymer was purified by Soxhlet extraction by washing subsequently with acetone, hexanes and chloroform. The polymer was recovered in the chloroform fraction (*M*ₙ = 29.6 kDa and PDI = 2.9).

### Example 9 (not according to the invention):

P((BDT-FTT(E))_{0.75}-(BDT-FTT(K1))_{0.25}) Monomers distannyl-BDT (100 mg, 0.11 mmol)), dibromo-FTT(E) (39 mg, 0.0825 mmol) and dibromo-FTT(Kl) were combined in a Schlenk flask with Pd(PPh₃)₄ (13 mg) in toluene (4.4 mL) and DMF (1.1 mL). The solution was heated to 120 °C and stirred for 48 h. The solution was poured into 100 mL methanol and the polymer was collected by filtration. The polymer was purified by Soxhlet extraction by washing subsequently with acetone, hexanes and chloroform. The polymer was recovered in the chloroform fraction (*M*ₙ = 20 kDa and PDI = 2.43).

### Example 10 (not according to the invention):

P((BDT-FTT(E))_{0.5}-(BDT-FTT(K2))_{0.5}) Monomers distannyl-BDT (100 mg, 0.11 mmol)), dibromo-FTT(E) (26 mg, 0.055 mmol) and dibromo-FTT(K2) (21 mg, 0.055 mmol) were combined in a Schlenk flask with Pd(PPh₃)₄ (7 mg) in toluene (4.4 mL) and DMF (1.1 mL). The solution was heated to 120 °C and stirred for 48 h. The solution was poured into 100 mL methanol and the polymer was collected by filtration. The polymer was purified by Soxhlet extraction by washing subsequently with acetone, hexanes and chloroform. The polymer was recovered in the chloroform fraction (*M*ₙ = 23 kDa and PDI = 1.4).

### Example 11 (not according to the invention):

P((BDT-FTT(P))_{0.5}-(BDT-FTT(K1))_{0.5}) Monomers distannyl-BDT (0.185 g, 0.21 mmol)), dibromo-FTT(P) (42 mg, 0.10 mmol) and dibromo-FTT(Kl) (44 mg, 0.10 mmol) were combined in a Schlenk flask with Pd(PPh₃)₄ (32 mg) in toluene (9 mL) and DMF (3 mL). The solution was heated to 120 °C and stirred for 48 h. The solution was poured into 100 mL methanol and the polymer was collected by filtration. The polymer was purified by Soxhlet extraction by washing subsequently with acetone, hexanes and chloroform. The polymer was recovered in the chloroform fraction (*M*ₙ = 16 kDa and PDI = 1.9).

### Example 12 (not according to the invention):

Synthesis of P((BDT-FTTM)_{0.25}-(BDT-FTTE)_{0.75}): In a 50 mL Schlenk flask, BDTE (150.0 mg, 0.166 mmol) and FTTE (55.93 mg, 0.118 mmol) and FTTM (14.77 mg, 0.039 mmol) and Pd(PPh₃)₄ (18.3 mg, 0.016 mmol) were added. The mixture was vacuumed and backfilled with argon twice before 7.5 mL of anhydrous toluene and 1.5 mL of anhydrous dimethylformamide were added. The solution was frozen by liquid nitrogen and then vacuumed, backfilled with argon and thawed twice before heated to 120 °C for 20 hours. The product was precipitated out in 40 mL methanol and purified by Soxhlet extraction, methanol (16 hour), acetone (8 hour), hexane (16 hour) and dichloromethane(4 hour) and then chloroform 2 hour. The portion from dichloromethane was the main product (62 mg, yield 43.1%) after precipitated from methanol and then dried overnight.

### Example 13 (not according to the invention):

Synthesis of P((BDT-FTTM)_{0.5}-(BDT-FTTE)_{0.5}) : In a 50 mL Schlenk flask, BDTE (100.0 mg, 0.106 mmol) and FTTE (24.86 mg, 0.053 mmol) and FTTM (19.69 mg, 0.053 mmol) and Pd(PPh₃)₄ (12.2 mg, 0.011 mmol) were added. The mixture was vacuumed and backfilled with Argon twice before 7.5 mL of anhydrous toluene and 1.5 mL of anhydrous dimethylformamide were added. The solution was frozen by liquid nitrogen and then vacuumed, backfilled with Argon and thawed twice before heated to 120 °C for 20 hours. The product was precipitated out in 40 mL methanol and purified by Soxhlet extraction, methanol (16 hour), acetone (8 hour), hexane (16 hour) and dichloromethane (4 hour) and then chloroform 2 hour. The portion from dichloromethane was the main product (60 and 24 mg respectively, yield 60.0%) after precipitated from methanol and then dried overnight.

Example 14: Synthesis of P((BDT-FTTM)_{0.75}-(BDT-FTTE)_{0.25}) : In a 50 mL Schlenk flask, BDTE (150.0 mg, 0.166 mmol) and FTTE (18.65 mg, 0.039 mmol) and FTTM (44.3, 0.118 mmol) and Pd(PPh₃)₄ (18.3 mg, 0.016 mmol) were added. The mixture was vacuumed and backfilled with Argon twice before 7.5 mL of anhydrous toluene and 1.5 mL of anhydrous dimethylformamide were added. The solution was frozen by liquid nitrogen and then vacuumed, backfilled with Argon and thawed twice before heated to 120 °C for 20 hours. The product was precipitated out in 40 mL methanol and purified by Soxhlet extraction, methanol (16 hour), acetone (8 hour), hexane (16 hour) and dichloromethane (4 hour) and then chloroform 2 hour. The portion from chloroform was the main product (116 mg, yield 85.5%) after precipitated from methanol and then dried overnight.

In closing, it should be noted that the discussion of any reference is not an admission that it is prior art to the present invention, especially any reference that may have a publication date after the priority date of this application. At the same time, each and every claim below is hereby incorporated into this detailed description or specification as an additional embodiment of the present invention.

### Device Fabrication and Measurement

ZnO sol-gel was prepared by dissolving zinc acetate dihydrate (220 mg, 1 mmol) and ethanolamine (62 mg, 1 mmol) into 2-methoxyethanol (2 mL) and stirred for 1 h in air. ITO-coated glass substrates were washed with detergent (15 min), DI water (2 × 15 min), acetone (15 min), and isopropanol (15 min) in an ultrasonication bath. The substrates were placed in a vacuum oven at 80 °C for 2 h and placed in a UV-ozone cleaner for 15 minutes. After filtration with a 0.2 µm PVDF syringe filter, ZnO sol-gel was spin-coated onto the top of the ITO substrate at 5000 rpm for 30 s (acceleration 5000 rpm). The substrate was annealed at 170 °C in air for 15 min and taken into glove box for deposition of the active layer. At the same time, 10 mg of P(BDT-FTT) and 16 mg of PC₇₀BM were mixed in *ortho*-xylene (1 mL) and stirred at 100 °C for 12 h. Diiodooctane (25 µL) was added to the solution and stirred for an additional 1 h, followed by filtration through a 0.45 µm PTFE syringe filter. Afterwards, the solution was coated on the substrate at 1,800, 2,000, and 2,200 rpm for 20 s. The substrate was solvent annealed inside of glass dishes for 1 h. After solvent annealing, the substrate was scratched at the edge to expose the ITO layer for the metal deposition. The substances were placed in the metal evaporator, and 14 nm of MoO₃ and 100 nm of Ag were deposited. The deposition speed for the MoO₃ was 0.5 Å/s. The deposition speed for Ag started at 0.5 Å/s until 5 nm was deposited. Afterward, the speed increased to 1-1.5 Å/s until 100 nm was deposited. The devices were encapsulated using UV-curable epoxy and a cover glass, and exposed to UV cure for 10 min.

The current density-voltage (J-V) curves were measured using a Keithley 2400 source meter. The photocurrent was measured under AM 1.5G illumination at 100 mW/cm² under Newport Thermal Oriel 91192 1000W solar simulator (4" x 4" beam size). The light intensity was calibrated by a mono-silicon detector (with KG-5 visible color filter) calibrated by National Renewable Energy Laboratory to minimize spectral mismatch.

**Table 1 depicts the solar cell performance of polymers from Examples 1-6 (not according to the invention).**

| Examples | FTT(E):FTT(P) ratio | V_{oc} (V) | J_{sc} (mA/cm²) | Fill Factor (%) | PCE (%) | Rₛ (Ω.cm²) | Rₛₕ (Ω) |
|---|---|---|---|---|---|---|---|
| 1 | 0:1 | 0.740 | 17.3 | 62.4 | 7.99 | 4.6 | 5723 |
| 2 | 0.3:0.7 | 0.75 | 16.5 | 65.0 | 8.07 | 4.6 | 9412 |
| 3 | 0.5:0.5 | 0.77 | 16.5 | 70.1 | 8.90 | 3.4 | 9286 |
| 4 | 0.7:0.3 | 0.76 | 16.1 | 61.1 | 7.48 | 5.0 | 5547 |
| 5 | 0.9:0.1 | 0.80 | 14.5 | 65.5 | 7.60 | 5.2 | 7567 |
| 6 | 1:0 | 0.80 | 16.0 | 68.6 | 8.74 | 4.1 | 10504 |

**Table 2 depicts the solar cell performance of polymers from Examples 7-9 (not according to the invention).**

| Polymer | FTT(E):FTT(K1) ratio | V_{oc} (V) | J_{sc} (mA/cm²) | Fill Factor (%) | PCE (%) | Rₛ (Ω.cm²) | Rₛₕ (Ω.cm²) |
|---|---|---|---|---|---|---|---|
| Example 7 | 0.25:0.75 | 0.81 | 15.89 | 59.95 | 7.72 | 7.25 | 620 |
| 8 | 0.5:0.5 | 0.77 | 17.29 | 64.79 | 8,26 | 5.19 | 779 |
| 9 | 0.75:0.25 | 0.79 | 16.83 | 67.84 | 9.04 | 4.34 | 815 |

**Table 3 depicts the solar cell performance of polymers from Example 10 (not according to the invention).**

| Polymer | FTT(E):FTT(K2) ratio | V_{oc} (V) | J_{sc} (mA/cm²) | Fill Factor (%) | PCE (%) | Rₛ (Ω.cm²) | Rₛₕ (Ω.cm²) |
|---|---|---|---|---|---|---|---|
| Example 10 | 0.5:0.5 | 0.79 | 17.3 | 68 | 9.30 | 2.8 | 956 |

**Table 4 depicts the solar cell performance of polymers from Example 11 (not according to the invention).**

| Polymer | FTT(P):FTT(K1) ratio | V_{oc} (V) | J_{sc} (mA/cm²) | Fill Factor (%) | PCE (%) | Rₛ (Ω.cm²) | Rₛₕ (Ω.cm²) |
|---|---|---|---|---|---|---|---|
| Example 11 | 0.5:0.5 | 0.81 | 15.77 | 63.49 | 8.11 | 4.97 | 713 |

### Example 12 (not according to the invention)

The polymer derivative of example 3 was further optimized in devices. A device structure was used which included a [6,6]-phenyl C61 butyric acid 2-hydroxyethyl ester (PCBE-OH) doped ZnO film as a interfacial layer. The resulting solar cell performance is depicted in Figure 1 and Table 5 below. The *V*_{oc} for this device slightly higher compared to the above fabrication method, and the *J*_{sc} increases to 17.4 mA/cm².

**Table 5**

| Polymer | Device Structure | V_{oc} (V) | J_{sc} (mA/cm²) | Fill Factor (%) | PCE (%) | Rₛ (Ω.cm²) | Rₛₕ (Ω.cm²) |
|---|---|---|---|---|---|---|---|
| Example 3 | ITO/ZnO/ZnO-PCBOH/active layer/MoO₃/Ag | 0.79 | 17.4 | 69.0 | 9.46 | 3.7 | 731 |

**Table 6**

| Polymer | Monomer ratio | | | V_{oc} | J_{sc} | FF | PCE |
|---|---|---|---|---|---|---|---|
| | FTTM | FTTE | BDTE | (V) | (mAcm⁻²) | (%) | (%) |
| Example 6 | 0 | 100 | 100 | 0.80 | 15.2 | 68.8 | 8.38 |
| Example 12 | 25 | 75 | 100 | 0.78 | 14.6 | 62.7 | 7.12 |
| Example 13 | 50 | 50 | 100 | 0.77 | 16.6 | 72.1 | 9.15 |
| Example 14 | 75 | 25 | 100 | 0.72 | 16.8 | 58.7 | 7.18 |

In closing, it should be noted that the discussion of any reference is not an admission that it is prior art to the present invention, especially any reference that may have a publication date after the priority date of this application. At the same time, each and every claim below is hereby incorporated into this detailed description or specification as an additional embodiment of the present invention.

## Claims

1. A polymer having two different sets of repeat units consisting essentially of 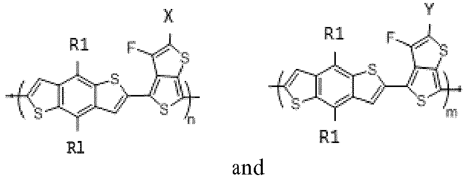
wherein R1 are selected from the group consisting of alkyl group, alkoxy group, aryl groups and combinations thereof:
n and m are greater than 1; and
x and y are different from each other and are selected from 2-ethylhexyl and propyl; the polymer being **characterised in that** the two sets of repeat units are a R1 substituted benzo[1,2-b:4,5-b']dithiophene with a 2-ethylhexyl substituted 3-fluorothieno[3,4-b]thiophene and a R1 substituted benzo[1,2-b:4,5-b']dithiophene with a propyl substituted 3-fluorothieno[3,4-b]thiophene.

2. The polymer of claim 1, wherein the aryl groups comprise heterocycles and fused heterocycles.

3. The polymer of claim 1, wherein the polymer is regio-regular.

4. The polymer of claim 1, wherein the polymer is regio-random.

5. The polymer of claim 1, wherein the ratio of 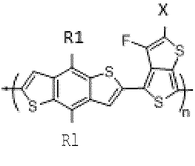 and 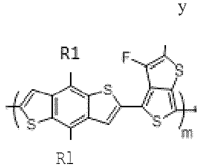 in the polymer is around 50:50.

6. The polymer of claim 1, wherein the two sets of repeat units are a benzo[1,2-b:4,5-b']dithiophene with a2-ethylhexyl substituted 3-fluorothieno[3,4-b]thiophene and a benzo[1,2-b:4,5-b']dithiophene with a propyl substituted 3-fluorothieno[3,4-b]thiophene in a ratio of around 50:50.

7. Use of the polymer of claim 1 as photovoltaic material in one or more photovoltaic devices.

8. Use of the polymer of claim 7, wherein the one or more photovoltaic devices are polymer solar cell devices or photodetector devices.

9. Use of the polymer of claim 1, wherein the polymer is used as active layer material in one or more electronic devices.

10. Use of the polymer of claim 9, wherein the one or more electronic devices are field effect transistors, light emitting devices, and sensors, electrochromic devices and capacitor.

## Patentansprüche

1. Polymer mit zwei verschiedenen Gruppen von Wiederholungseinheiten, im Wesentlichen von: 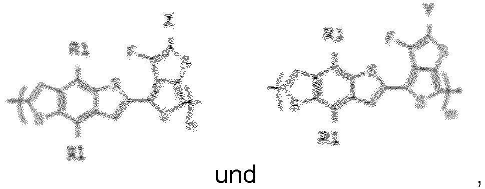
wobei R1 ausgewählt sind aus der Gruppe bestehend aus einer Alkylgruppe, Alkoxygruppe, Arylgruppen und Kombinationen davon;
n und m größer als 1 sind; und
x und y sich voneinander unterscheiden und ausgewählt sind aus 2-Ethylhexyl und Propyl; wobei das Polymer **dadurch gekennzeichnet ist, dass** die beiden Gruppen von Wiederholungseinheiten ein R1 substituiertes Benzo[1,2-b:4,5-b']dithiophen mit einem 2-Ethylhexyl substituierten 3-Fluorthienol[3,4-b]thiophen und ein R1 substituiertes Benzo[1,2-b:4,5-b']dithiophen mit einem Propyl substituierten 3-Fluorthieno[3,4-b]thiophen sind.

2. Polymer nach Anspruch 1, wobei die Arylgruppen Heterocyclen und kondensierte Heterocyclen umfassen.

3. Polymer nach Anspruch 1, wobei das Polymer regioregulär ist.

4. Polymer nach Anspruch 1, wobei das Polymer regiorandom ist.

5. Polymer nach Anspruch 1, wobei das Verhältnis von 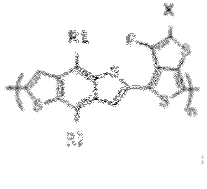 und 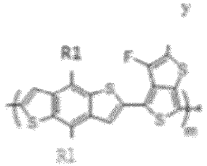 in dem Polymer etwa 50:50 beträgt.

6. Polymer nach Anspruch 1, wobei die beiden Gruppen von Wiederholungseinheiten Benzo[1,2-b:4,5-b']dithiophen mit einem 2-Ethylhexyl substituierten 3-Fluorthienol[3,4-b]thiophen und ein Benzo[1,2-b:4,5-b']dithiophen mit einem Propyl substituierten 3-Fluorthieno[3,4-b]thiophen in einem Verhältnis von 50:50 sind.

7. Verwendung des Polymers nach Anspruch 1 als photovoltaisches Material in einem oder mehreren photovoltaischen Vorrichtungen.

8. Verwendung des Polymers nach Anspruch 7, wobei die eine oder die mehreren photovoltaischen Vorrichtungen polymere Solarzellenvorrichtungen oder Photodetektorvorrichtungen sind.

9. Verwendung des Polymers nach Anspruch 1, wobei das Polymer als ein aktives Schichtmaterial in einer oder mehreren elektronischen Vorrichtungen verwendet wird.

10. Verwendung des Polymers nach Anspruch 9, wobei die eine oder die mehreren elektronischen Vorrichtungen Feldeffekttransistoren, lichtemittierende Vorrichtungen und Sensoren, elektrochrome Vorrichtungen und Kondensator sind.

## Revendications

1. Polymère ayant deux ensembles différents de motifs répétitifs consistant essentiellement en 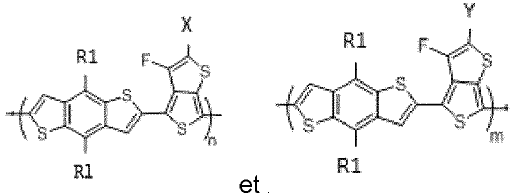 R1 étant choisis parmi le groupe constitué d'un groupe alkyle, d'un groupe alcoxy, de groupes aryle et de combinaisons de ceux-ci :
n et m étant supérieurs à 1 ; et
x et y étant différents l'un de l'autre et étant choisis parmi le 2-éthylhexyle et le propyle ;
le polymère étant **caractérisé en ce que** les deux ensembles de motifs répétitifs étant un benzo[1,2-b:4,5-b']dithiophène substitué par R1 avec un 3-fluorothiéno[3,4-b]thiophène substitué par 2-éthylhexyle et un benzo[1,2-b:4,5-b']dithiophène substitué par R1 avec un 3-fluorothiéno[3,4-b]thiophène substitué par un propyle.

2. Polymère selon la revendication 1, les groupes aryle comprenant des hétérocycles et des hétérocycles fusionnés.

3. Polymère selon la revendication 1, le polymère étant regio-régulier.

4. Polymère selon la revendication 1, le polymère étant régio-aléatoire.

5. Polymère selon la revendication 1, le rapport de 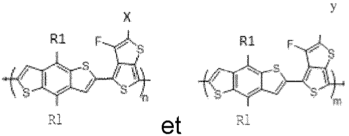 dans le polymère étant d'environ 50:50.

6. Polymère selon la revendication 1, les deux ensembles de motifs répétitifs étant un benzo[1,2-b:4,5- b']dithiophène avec un 3-fluorothiéno[3,4-b]thiophène substitué par un 2-éthylhexyle et un benzo[l,2-b:4,5- b']dithiophène avec un 3-fluorothiéno[3,4-b]thiophène substitué par un propyle dans un rapport d'environ 50:50.

7. Utilisation du polymère selon la revendication 1 comme matériau photovoltaïque dans au moins un dispositif photovoltaïque.

8. Utilisation du polymère selon la revendication 7, l'au moins un dispositif photovoltaïque étant des dispositifs à cellules solaires en polymère ou des dispositifs photodétecteurs.

9. Utilisation du polymère selon la revendication 1, le polymère étant utilisé comme matériau de couche active dans au moins un dispositif électronique.

10. Utilisation du polymère selon la revendication 9, l'au moins un dispositif électronique étant des transistors à effet de champ, des dispositifs émetteurs de lumière, et des capteurs, des dispositifs électrochromiques et un condensateur.
